# EUROPEAN PATENT SPECIFICATION

(11) **EP 3 935 725 B1**
(45) Date of publication and mention of the grant of the patent: **23.07.2025**
(21) Application number: 19711270.9
(22) Date of filing: 08.03.2019
(51) Int. Cl.: H02P 6/08, H02K 7/14, H02K 11/215, H02P 29/02, B25F 5/00, H02K 11/33, H02P 3/06, H03K 17/97

(54) **TRIGGER APPARATUS FOR POWERED DEVICE, POWERED DEVICE, AND METHOD OF CONTROLLING AN OPERATION OF A POWERED DEVICE**
AUSLÖSEVORRICHTUNG FÜR EINE ANGETRIEBENE VORRICHTUNG, ANGETRIEBENE VORRICHTUNG UND VERFAHREN ZUM STEUERN EINES BETRIEBS EINER ANGETRIEBENEN VORRICHTUNG
APPAREIL DE DÉCLENCHEMENT POUR DISPOSITIF ALIMENTÉ, DISPOSITIF ALIMENTÉ, ET PROCÉDÉ DE COMMANDE D'UNE OPÉRATION D'UN DISPOSITIF ALIMENTÉ

(43) Date of publication of application: 12.01.2022
(73) Proprietor: Mirka Oy, 66850 Jeppo (FI)
(72) Inventor: STORBJÖRK, Andreas, 65610 Korsholm (FI); HOLMQVIST, Tobias, 65300 Vaasa (FI); WESTERLUND, Jan-Anders, 68630 Jakobstad (FI)
(74) Representative: Hoffmann Eitle
(86) International application number: PCT/EP2019/055837
(87) International publication number: WO 2020/182273

(56) References cited:
- EP-A2- 2 524 773
- WO-A2-2007/002180

## Description

### Technical field

The present disclosure generally relates to the control of powered devices, and more particularly to a trigger apparatus for a powered device, a powered device and a method of controlling an operation of the powered device.

### Background art

Known powered devices, that is, devices using a power source to operate, include trigger mechanisms allowing users to variably control an operation of the device, such as the rotation speed of a motor in a sander or other power tool.

More specifically, the user operates the trigger mechanism to cause an increase or decrease in the quantity of operation. The trigger mechanism indicates a quantity of operation desired by the user, and a controller in the device adjusts the operation to match the value desired by the user.

These known trigger mechanisms typically include a switch, which is used as a power switch, and a potentiometer. The switch is connected in series between the power source and the other electric/electronic components of the device, and controlling whether power flows through the electronic components or not. In other words, the switch is used to pass current to the electronic components. The potentiometer generates an output signal (usually an output voltage) dependent on how much a trigger button (or other input means) is depressed by the user. A controller then adjusts the operation based on the signal generated by the potentiometer.

However, potentiometers have a limited stroke and are bulky, accordingly, these known trigger mechanisms offer limited variability of control and occupy a large amount of space, which is especially critical for portable devices.

Furthermore, in these trigger mechanisms, the power for the electric/electronic components is carried through the switch, which experiences significant wear, thereby reducing the life and as a consequence the reliability of the trigger mechanism.

Accordingly, there is therefore a need for a trigger mechanism which improves the reliability and variability of control of a powered device.

WO 2007/002180 A2 describes a powered surgical tool with a housing that contains a power generating unit such as a motor. A control module is disposed in a shell that is mounted in the housing. The control module contains a control circuit for regulating the actuation of the power generating unit. The power generating unit emits a signal representative of the operating state of the unit that is transmitted through the structural material forming the shell. Also internal to the control module shell is a sensor that monitors the signal emitted by the power generating unit. This signal output by the sensor is applied to the control circuit. The control circuit, based on the sensor signal regulates actuation of the power generating unit. The power generating unit is a motor, the signal emitted is the magnetic field that varies with rotor position. The sensor monitors the strength of this field.

EP 2 524 773 A2 describes an electronic power apparatus includes a housing, a pair of input power pins and a pair of output power pins mounted on a power circuit board, and power components mounted on the power circuit board and electrically connected to the input power pins and the output power pins to modulate a supply of power from the input power pins to the output power pins. A control unit of the electronic power apparatus is arranged on a control circuit board disposed at a distance from the power circuit board inside the housing. The output power pins project through corresponding through-holes through the control circuit board to an outside part of the housing, the output pins having at least one side protrusion arranged to spatially support the control circuit board with respect to the power circuit board inside the housing.

### Summary of the invention

Embodiments of the present invention have been devised which address at least some of the above-identified problems.

According to the invention, there is provided a trigger apparatus for a powered device, such as a power tool, the powered device comprising a trigger being operable by a user to move from a first position to at least one second position so as to control an operation of the powered device. The trigger apparatus comprises: a linear Hall effect sensor for measuring a change in a magnetic field associated with the trigger being moved from the first position to the at least one second position, and configured to generate a sensor signal for controlling the operation of the powered device based on the change in the magnetic field; a power module configured to power the linear Hall effect sensor upon reception of an activation signal for indicating that the trigger apparatus is to be activated; and an activation switch configured to generate the activation signal when the trigger is moved from the first position.

The trigger may be of any known kind such as a button, a slider, a rotatable knob, etc., and the user may move the trigger by pushing, pulling or displacing the trigger in any other way. The trigger may be configured to have a linear movement, a movement along a curve, or a rotation about an axis.

The first position may be an initial, resting position of the trigger when the powered tool is not operated by a user.

The trigger may be reversibly movable between the first position and the at least one second position, so as to allow the user to control of successive operations of the powered device.

Each of the at least one second position may be a position along the predetermined movement of the trigger, and each second position may be associated with a specific operation of the powered device.

In embodiments where there are more than one second position, a second position located nearer the first position may be associated with a first operation value (such as a rotation speed of a motor, an output flow amount etc.), and the second position located farther from the first position may be associated with a second operation value greater than the first operation value. Accordingly, the user may determine the operation value by moving the trigger from the first position to the nearer second position to cause an operation of the powered device to with the first operation value or moving the trigger to the second position located farther from the first position to cause an operation of the powered device with the second operation value.

The activation switch is a microswitch.

The activation signal may be generated, for example, when the state of the activation switch switches. The activation switch may be configured such that the activation signal is generated when the activation switch switches from an off state to an on state (that is, when terminals of the activation switch make electrical contact with one another, or when the density of the magnetic field sensed by the binary Hall effect sensor increases past the threshold of the binary Hall effect sensor), as this should minimise power consumption when the trigger is at the first position. However, the activation signal may also be generated when the activation switch switches from an on state to an off state.

The activation signal is not necessarily generated when the trigger is moved from the first position by a minute amount. Instead, there may be a minimum movement required (i.e. a minimum movement threshold) for the activation switch to generate the activation signal.

When in use, the activation switch generates the activation signal. The activation signal indicates that the linear Hall effect sensor should be powered. Then, the power module receives the activation signal and powers at least the linear Hall effect sensor, thereby allowing the linear Hall effect sensor to measure a magnetic field and generate the sensor signal.

According to the invention, the power module may be connected, directly or indirectly, to a power source, such as a battery or AC mains, and supply the power from the power source to the linear Hall effect sensor, and optionally other components of the trigger apparatus. When necessary, the power module may be configured to convert AC power from the power source to a DC power suitable for the linear Hall effect sensor.

Thus, by using the power module to selectively power the linear Hall effect sensor, and optionally the other components of the trigger apparatus, the power consumption of the trigger apparatus may be reduced when the trigger is not operated by the user.

The linear Hall effect sensor, once powered, measures the magnetic field in its vicinity and generates a sensor signal based on the measured magnetic field. A change in the magnetic field around the linear Hall effect sensor can be detected by the trigger apparatus, and the detected change is associated with a movement of the trigger. That is, it is assumed that there is a causal relationship between a movement of the trigger and a change in the magnetic field in the vicinity of the linear Hall effect sensor, such that a change in the magnetic field detected by the trigger apparatus is considered to indicate a corresponding movement of the trigger.

The linear Hall effect sensor may either generate, based on the measured magnetic field, a sensor signal representing the density of the magnetic field at a time instant, in which case another component may, upon reading the sensor signal, detect a change in the magnetic field by comparing two values of the sensor signal.

Alternatively, the linear Hall effect sensor may be configured to measure the change in the magnetic field and to generate a sensor signal representing the change in magnetic field, that is, a signal based on the density of the magnetic field at a time instant relative to the density of the magnetic field at a previous time instant.

Accordingly, the linear Hall effect sensor is suitable for measuring a change in the magnetic field, either by measuring the change in the magnetic field itself or allowing the change to be measured by another component reading the sensor signal.

Thus, the sensor signal is generated based on the magnetic field.

The Hall effect sensor is defined as linear because it allows for an output signal which is non-binary, as is the case with binary Hall effect sensors which simply detect the presence of a magnetic field of sufficient density (i.e. above a predefined threshold) or not. However, the relationship between the measured magnetic field and the output of the sensor (i.e. the sensor signal) is not necessarily linear.

The change in the magnetic field may be detected by hardware means (e.g. circuitry) coupled to the linear Hall effect sensor and/or software means configured to compare the magnetic field density measured at two or more different time instants, and determine a change based on the comparison.

Accordingly, as the sensor signal is generated based on the measured magnetic field, it can therefore serve as an indication of the movement of the trigger (that is, an indication of an amount or distance by which the trigger has moved, or an indication of a displacement of the trigger) and be used to variably control the operation of the powered device to have an operation value corresponding to a movement of the trigger by the user.

The present inventors have recognised that the combined use of a linear Hall effect sensor and the activation switch provides for a particularly reliable trigger apparatus which allows a device such as a power tool to be controlled with a high variability.

More specifically, the stroke of the linear Hall effect sensor is sufficiently long to allow a precise control of the operation of the device, and thus improving the variability of control of the device.

Additionally, the linear Hall effect sensor is less sensitive to environmental conditions such as dust, moisture, vibrations or shock impacts, and thus improves the reliability of the trigger apparatus.

Furthermore, the activation switch is used to generate an activation signal when the trigger is moved by the user from the first position, allowing the linear Hall effect sensor to be selectively activated.

Thus, the combination of the linear Hall effect sensor, and the activation switch provides a hardware redundancy increasing the safety of the powered device which is thus more likely to comply with safety regulations.

Moreover, the activation switch does not function as a power switch which is connected in series between the components of the trigger apparatus and the power source supplying power to these components and which is used to pass current to these components. Instead, it is merely used to generate an activation signal which is received by the power module and which indicates that the linear Hall effect sensor is to be powered. In other words, the activation switch is only used for logic. Thus, the level of power flowing through the activation switch can be made lower, thereby reducing the wear of the activation switch and extending the life of the activation switch, which in turn improves the reliability of the trigger apparatus.

A separate switch may be provided instead to have the functionality of the switch in known trigger mechanism, to be placed between the power source and the power module, and which may be manually operated by the user to connect or disconnect the power module and the components of the trigger apparatus from the power source. If such a switch is present in the powered device, it would be defined as the power switch. However, this separate power switch is not always necessary if the power source is manually removable from the powered device including the trigger apparatus, for example if it is a removable battery pack or if the powered device can be unplugged from the AC mains.

Thus, a trigger apparatus suitable for a power tool comprises a linear Hall effect sensor for measuring a change in a magnetic field associated with a movement of the trigger, and for generating a sensor signal, the sensor signal being for indicating a desired operation of the power tool.

The trigger apparatus comprises an activation switch and a power module for reducing risks of unintended operation of the power tool. The activation switch is for indicating that the linear Hall effect sensor is to be activated, and the power module being for powering the linear Hall effect sensor.

Hence, with the above trigger apparatus, an improved reliability and variability of control of a powered device is therefore obtained.

Although the trigger apparatus is preferably suitable for a power tool, such as a sander (e.g. a rotary, orbital, random orbital, geared eccentric orbital, belt or drum sander), a polisher (e.g. a rotary, orbital, random orbital, geared eccentric orbital polisher), a grinder, an electrical drill, a vacuum cleaner, a benchtop saw etc., it may also be used in any other powered device allowing a user to variably control an operation of the device, for example in a remote controller for remote controlled vehicles, household appliances, etc.

The activation switch is a microswitch.

Accordingly, the operation of the activation switch is not dependent on the density of the magnetic field surrounding the activation switch. This reduces the risk that a sensor signal is accidentally generated whilst the device is not operated by the user, because even if an external magnetic source (i.e. outside the powered device) is brought into close proximity with the linear Hall effect sensor (which would, if the sensor was powered, generate a sensor signal triggering the device into operation), the linear Hall effect sensor is not activated until the user operates the trigger, and therefore the linear Hall effect sensor cannot generate such undesired sensor signal. Accordingly, the microswitch, by causing the linear Hall effect sensor to be powered only when the trigger is not in the first position, reduces the risk of accidental operation, thereby improving the reliability of the trigger apparatus.

Additionally, the small dimensions of the microswitch allow for a compact trigger apparatus.

Preferably, the trigger apparatus may comprise the trigger and may be configured such that a movement of the trigger from the first position to the at least one second position causes a change in the magnetic field measured by the linear Hall effect sensor.

Accordingly, the configuration of the trigger apparatus ensures that a movement of the trigger can be detected, by detecting changes in the magnetic fields resulting from the movement using the linear Hall effect sensor.

Preferably, the trigger apparatus comprises a magnetic element for generating a magnetic field.

The magnetic element may be any element for generating a magnetic field having a density which can be measured by the linear Hall effect sensor, such as a permanent magnet or a coil.

Accordingly, with the magnetic element, it is possible to ensure that a magnetic field of sufficient density is present in the vicinity of the linear Hall effect sensor, such that the linear Hall effect sensor can detect at least the magnetic field generated by the magnetic element.

Additionally, if the magnetic element is a coil, the trigger apparatus may be configured to selectively stop the magnetic element from generating the magnetic field. For example, the trigger apparatus may be configured such that the coil is shorted when the trigger is at the first position. Accordingly, unintended measurements of the magnetic field may be reduced, thereby further reducing risks of accidental operation of the power tool or powered device, which in turns further improves the reliability of control of the powered device.

Preferably, the trigger apparatus is configured such that the trigger being moved from the first position to the second position causes a corresponding change to a positional relationship between the magnetic element and the linear Hall effect sensor by way of movement of the trigger.

In this context, the movement of the magnetic element need not be the same as the movement of the trigger to be considered as a corresponding movement, but can instead be a proportional, inversely-proportional, or there may be another predetermined relationship between the two movements.

The positional relationship may include one or more of the distance between the magnetic element and the linear Hall effect sensor, the position of the magnetic element relative to an axis along which the linear Hall effect sensor measures the magnetic field, and the orientation of the magnetic field generated by the magnetic element relative to the linear Hall effect sensor.

For example, the trigger apparatus may be configured such that the magnetic element is moved nearer the linear Hall effect sensor as the trigger is moved away from the first position, which would increase the density of the magnetic field measured by the linear Hall effect sensor.

Accordingly, as the movement of the trigger causes a change in the positional relationship, the density of the magnetic field measured by the linear Hall effect sensor changes as well, and the movement of the trigger can be detected.

Preferably, the trigger is operable by the user to reversibly move between the first position and the at least one second position, the power module is configured to stop powering the linear Hall effect sensor upon reception of a deactivation signal for indicating that the trigger apparatus is to be deactivated, and the activation switch is configured to generate the deactivation signal when the trigger is moved to the first position.

As with the activation signal, the deactivation signal may be generated when the state of the activation switch switches, either from an on state to an off state or vice-versa. Similarly, the deactivation signal is not necessarily generated when the trigger is moved exactly to the first position, but may be generated when the trigger is in close proximity to the first position.

Accordingly, the user can deactivate the linear Hall effect sensor, and therefore cause the operation of the power tool to cease, by moving the trigger back to the first position. Additionally, the deactivation of the linear Hall effect sensor when the trigger is at the first position reduces risks of unintentional generation of a sensor signal, which could otherwise cause an unwanted operation of the device.

According to the invention, the trigger apparatus further comprises a controller for receiving the sensor signal and for generating one or more control signals to control the operation of the powered device, and the power module is configured to power the controller upon reception of the activation signal.

The controller may comprise a processing unit, such as a microcontroller or a CPU, which is configured to execute instructions stored in memory.

Accordingly, signals to control, for example a motor or an actuator of the powered device can be generated based on the sensor signal (that is, based on an indication of the movement of the trigger), and, by activating the controller only when the trigger is moved from the first position, the unintended generation of control signals can be hindered, thereby improving the reliability of the device, and the power consumption of the trigger apparatus can be reduced.

Additionally, the linear Hall effect sensor may not need to measure the change in the magnetic field, but instead the controller may be configured to receive the sensor signal and compare the sensor signal value from at least two different time instants, thus determining a change based on the comparison.

According to the invention, the controller is configured to generate a second activation signal for causing the power module to continue to power the controller for a specific duration.

In these cases, the power module is configured to receive the activation signal generated by the activation switch or the second activation generated by the controller, and to power at least the linear Hall effect sensor upon reception of the activation signal or the second activation signal.

The specific duration may be a predetermined period of time from reception of the second activation signal or another, subsequent signal, or it may be a period of time ending upon occurrence of a predetermined event.

Optionally, the power module may, upon reception of the second activation signal, continue to power at least one of the linear Hall effect sensor, the magnetic element, and other components of the trigger apparatus.

Accordingly, the controller can be maintained activated for a specific duration to perform processing for data logging, wireless communications, or any other additional functionality of the trigger apparatus.

Preferably, the controller is configured to receive the deactivation signal from the activation switch and transmit a second deactivation signal to the power module, and the power module is configured to stop powering the controller upon reception of the second deactivation signal.

The controller may process the received deactivation signal to generate the second deactivation signal, or may simply relay the received deactivation signal as received.

The power module may optionally be configured to also stop powering at least one of the linear Hall effect sensor and the magnetic element upon reception of the second deactivation signal.

Accordingly, the controller can determine, from the deactivation signal, the status of the activation switch and that the trigger is moved back to the first position, and the controller can ensure that it is powered for a sufficient time to carry out any necessary function.

According to a preferred embodiment, there is provided a powered device, such as a power tool, comprising a trigger apparatus. The powered device comprises a trigger being operable by a user to move from a first position to at least one second position so as to control an operation of the powered device. The trigger apparatus comprises a linear Hall effect sensor for measuring a change in a magnetic field associated with the trigger being moved from the first position to the at least one second position, and configured to generate a sensor signal based on the measured magnetic field, for controlling the operation of the powered device; a power module configured to power the linear Hall effect sensor upon reception of an activation signal for indicating that the trigger apparatus is to be activated; and an activation switch configured to generate the activation signal when the trigger is moved from the first position. The powered device also comprises an electric motor and a power supply module coupled or to be coupled to a power source and configured to provide power to at least one of the power module of the trigger apparatus and the electric motor. The powered device is configured to operate the electric motor based on the sensor signal from the linear Hall effect sensor.

The electric motor may be any type of motor allowing a variable control of the speed, such as a brushless DC motor, an induction machine with a variable-frequency drive, etc. Thus, the user can reliably control the speed of the electric motor with improved accuracy.

The control signals generated by the controller are used to operate the electric motor at the speed determined by the user, based on the sensor signal and an indication of the actual speed of the motor. The actual speed of the motor can be measured using any known method, including a Hall effect sensor detecting magnets placed at regular intervals on a radius of the rotor or by measuring the Back EMF produced in each phase windings.

The power source can be a DC or an AC power source, and it may be an internal power source (i.e. part of the powered device) or an external power source electrically coupled to the power supply module. For example, the power source may be a battery pack coupled to the powered device, or it may be mains electricity (such as grid power) to which the power supply module is connected.

The powered device comprises the trigger for allowing a user to input a desired operation of the powered device, the electric motor for generating the rotational force necessary for the operation of the powered device, and the power supply module for providing power to the electric motor and other components of the device. The powered device also comprises the trigger apparatus for controlling the operation of the powered device based on a measured change in the magnetic field associated with the movement of the trigger.

With such a powered device, the user can control the powered device with an improved reliability and variability of control.

Preferably, the powered device comprises a drive circuit for driving the electric motor, and the trigger apparatus in the powered device comprises a controller configured to generate one or more control signals to control the drive circuit, based on the sensor signal. The activation switch is configured to disable at least one input of the drive circuit when the trigger is at the first position so as to interrupt an operation of the electric motor.

Accordingly, the operation of the electric motor can be disabled when the trigger is at the first position, and an unintended operation of the electric motor of the powered device can be avoided.

According to the invention, there is provided a method of controlling an operation of a powered device comprising a trigger operable by a user to move from a first position to at least one second position so as to control the operation of the device. The method comprises generating, using an activation switch, an activation signal when the trigger is moved from the first position; powering a linear Hall effect sensor upon generation of the activation signal; measuring, using the linear Hall effect sensor, a change in a magnetic field associated with the trigger being moved from the first position to the at least one second position; generating, a sensor signal for controlling the operation of the powered device based on the change in the magnetic field; and controlling the operation of the device based on the sensor signal.

With such a method, the reliability and variability of control of the powered device is improved.

In embodiments or implementations described herein, the controller may be configured to receive the activation signal generated by the activation switch, and to determine, based on the reception of the activation signal, the state of the activation switch.

In some embodiments or implementations described herein, the linear Hall effect sensor may be shielded from external magnetic fields (that is, magnetic fields generated by other components of the powered device or elements external to the powered device), for example by using a mu-metal, to reduce the sensitivity of the linear Hall effect sensor to changes in external magnetic fields thereby more accurately measuring changes in the magnetic field generated by the magnetic element.

In some embodiments or implementations described herein, the activation switch may have at least one output coupled to an input of the power module and/or the controller. When the trigger is moved from the first position, the at least one output of the activation switch changes to a predetermined state indicating that an activation of the linear Hall effect sensor is to be performed (that is, an activation signal is generated). Optionally, when the trigger is moved back to the first position, the same output or another output of the activation switch changes to a second predetermined state indicating that a deactivation of the activation switch is to be performed (that is, a deactivation signal is generated).

In some embodiments or implementations described herein, the sensor signal is said to be generated by the linear Hall effect sensor and received by the controller. However, the linear Hall effect sensor need not generate an actual signal. Instead the controller may be configured to operate the linear Hall effect sensor and read a value within the linear Hall effect sensor. In other words, the controller may generate a separate sensor control signal to read a value from the linear Hall effect sensor and obtain a value indicating the magnetic field measured by the linear Hall effect sensor.

In some embodiments or implementations described herein, each of the activation signal, the second activation signal, the deactivation signal and the second deactivation signal may correspond to a brief signal, such as an impulse or an edge of a binary signal (either a rising edge or a falling edge).

In some embodiments or implementations described herein, an activation signal may correspond to one of a rising edge and a falling edge of a binary digital signal, and the corresponding deactivation signal may be the other one of the rising edge and the falling edge of the binary digital signal. In this context, the activation signal and the deactivation signal, both generated by the activation switch, correspond to each other, and the second activation signal and the second deactivation signal, both generated by the controller, correspond to each other.

In embodiments and implementations described herein, the switching elements may be transistors, such as Field-effect transistors (FETs) (e.g. Si MOSFETS, GaN MOSFETs, SiC MOSFETs, etc.), Bipolar junction transistors (BJTs), insulated-gate bipolar transistors (IGBTs), thyristors, or other known types of switches.

The present disclosure is also directed at the use of a trigger apparatus in a powered device comprising a trigger operable by a user to move from a first position to at least one second position. The trigger apparatus, when in use, allows for the control of an operation of the powered device based on a measured change in a magnetic field associated with a movement of the trigger.

### Brief description of the drawings

In the following, aspects of the present disclosure will be described by reference to the following Drawings, by way of example only, in which:
Figure 1 shows a schematic view of a trigger apparatus for a powered device according to a first embodiment;
Figures 2A to 2C show the output of the microswitch and the sensor signal as a function of the position of the push button;
Figures 3A to 3C show a trigger apparatus for a powered device and the trigger;
Figure 4 shows a schematic view of the trigger apparatus in an electric sander as a powered device;
Figure 5 shows a schematic view of the logic gate, and parts of the motor drive and the BLDC motor;
Figures 6A to 6D show a schematic view of the push button, the microswitch and the linear Hall effect sensor at different time instants;
Figures 6E shows the output of the microswitch and the sensor signal S at the different time instants;
Figure 6F shows the speed of the BLDC motor at the different time instants; and
Figures 7A and 7B show a schematic view of a trigger, a linear Hall effect sensor and a coil, according to a second embodiment.
Figures 8A and 8B show schematic views of the logic gate, and parts of the motor drive and the BLDC motor according to a modification;

### Detailed description of embodiments

### [First Embodiment]

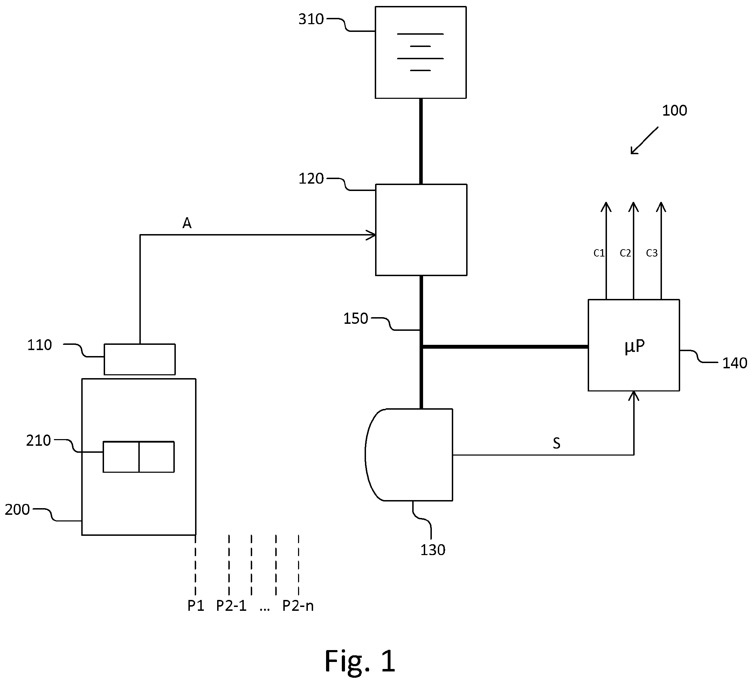

Figure 1 shows a schematic view of a trigger apparatus 100 for a powered device. The power device comprises a push button 200 as a trigger, to be operated by the user to move between a first position P1 and at least one second position P2-1 P2-n.

In the present embodiment, the first position P1 corresponds to an initial position against which the trigger is biased by a helical spring (not shown) when not operated by a user. In other words, the trigger is reversibly movable between the first position P1 and the at least one second position P2-1 ~ P2-n.

The trigger 200 comprises a permanent magnet 210, for example a neodymium magnet, as a magnetic element, which generates a constant magnetic field.

A microswitch 110 is configured to cooperate with the trigger 200, such that the microswitch 110 is in an off state when the trigger 200 is at the first position P1, and the microswitch 110 switches to an on state when the trigger 200 is moved from the first position P1. More specifically, when the trigger 200 is moved from the first position P1, the electric terminals of the microswitch 110 are made to contact each other, and an activation signal A is generated from the microswitch 110.

The microswitch outputs a binary signal, and to generate the activation signal A, the output of the microswitch switches to a logical high and is maintained at a logical high until the trigger 200 is moved back to the first position P1, at which point the output of the microswitch switches back to a logical low.

A power module 120 receives the activation signal A. The power module 120 is electrically coupled to a Li-ion battery 310 providing a 10.8V DC power, for example. The power module 120 receives power from the battery 310 to selectively power a linear Hall effect sensor 130 and a controller 140, via a low-voltage power bus 150.

The power module 120 comprises a DC-DC converter (not shown) configured to transform the (exemplary) 10.8V power provided by the battery to a lower voltage required to power the linear Hall effect sensor 130 and the microcontroller 140, and a voltage regulator to maintain the voltage on the voltage bus 150. When the power module 120 receives the activation signal A, the power module 120 provides power to the linear Hall effect sensor 130 and the microcontroller 140 via the low-voltage power bus 150, until reception of a second deactivation signal from the microcontroller 140.

Upon being powered, the linear Hall effect sensor 130 measures a magnetic field in its vicinity. The linear Hall effect sensor 130 is oriented towards the trigger 200 and the permanent magnet 210 in the trigger 200.

When the trigger 200 is operated by the user to move from the first position P1 towards one of the second positions P2-1 ~ P2-n, the permanent magnet 210 moves closer to the linear Hall effect sensor 130, which causes the density of the magnetic field measured by the linear Hall effect sensor 130 to increase as the trigger 200 is moved closer to the linear Hall effect sensor 130.

The linear Hall effect sensor 130 generates a sensor signal S based on the measured magnetic field and with an amplitude proportional to the density of the measured magnetic field.

The microcontroller 140 comprises a non-volatile memory (not-shown) for storing instructions, such as a ROM, EPROM, EEPROM or flash memory, a processing unit (not shown) for executing the instructions stored on the non-volatile memory, such as a CPU, and a RAM used by the processing unit when executing the instructions.

The microcontroller 140 receives the sensor signal S and detects a change in the measured magnetic field, by comparing the magnetic field measured by the linear Hall effect sensor 130 at two different time instants. When a change in the measured magnetic field is detected, this is associated with a movement of the trigger 200. The microcontroller 140 determines a presumed amount by which the trigger 200 was moved based on the amount of change detected in the magnetic field. The microcontroller 140 generates three control signals C1, C2 and C3 to control each phase of a three-phased electric motor, so as to operate the electric motor in accordance with the amount by which the trigger 200 is considered to have been moved by the user.

Although not shown on Figure 1, the microcontroller 140 also receives the activation signal A from the microswitch 110 and can determine the state of the microswitch 110.

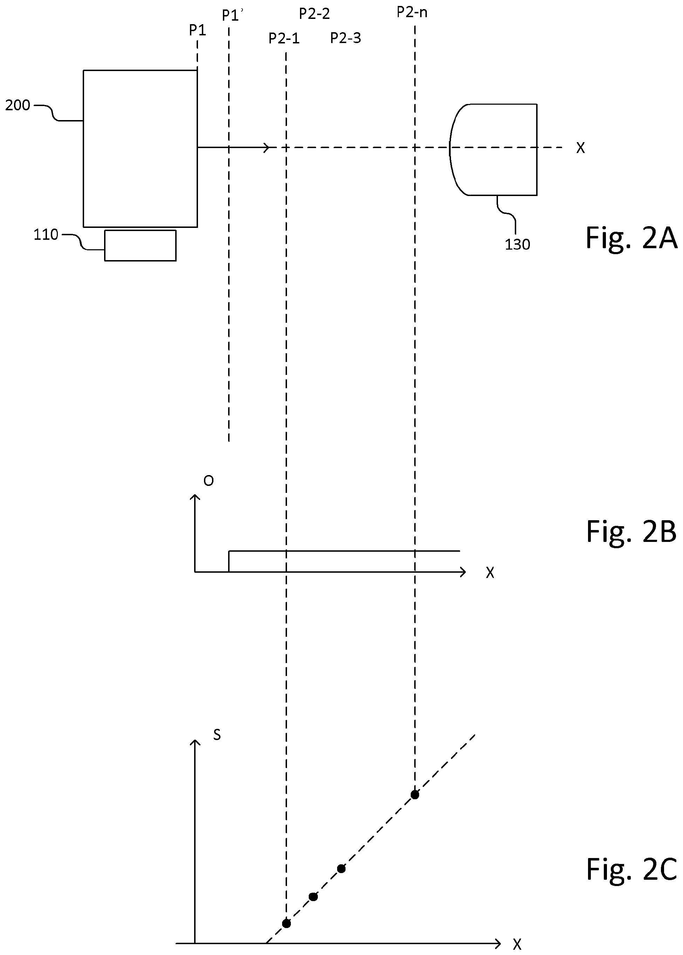

Figures 2A to 2C show the output of the microswitch signal A and the sensor signal S as a function of the position of the push button 200 relative to the linear Hall effect sensor 130. The push button 200 is configured to move along an axis X.

Figure 2A shows the first position P1, the position P1' in the near proximity of the first position where the microswitch 110 switches its state, and a plurality of second positions P2-1 to P2-n, which are consecutively nearer the linear Hall effect sensor 130.

As shown on Figure 2B, the microswitch 110 does not switch when the trigger is moved from the first position P1 by an infinitesimal amount, but only once the trigger is moved to a position P1' located in the near proximity of the first position P1, to avoid accidental activation of the device and due to the physical limitations of the microswitch.

The output of the microswitch 110 is at a logical low whilst the push button 200 is at the first position P1 or between the first position P1 and the position P1' and switches to a logical high when the push button 200 is moved from the first position P1 past the position P1'. The output of the microswitch 110 continues to be a logical high until the trigger 200 is moved back to the first position P1 (or, at least back until position P1').

As shown on Figure 2C, when the push button 200 is at or near the first position P1, the sensor signal S is zero, or a negligibly low value. When the push button 200 is moved to near the second position P2-1, the amplitude of the sensor signal S starts to increases and continuously increases as the push button 200 is further moved along the axis X towards the linear Hall effect sensor 130. Accordingly, the amplitude of the sensor signal S is proportional to a movement of the trigger 200.

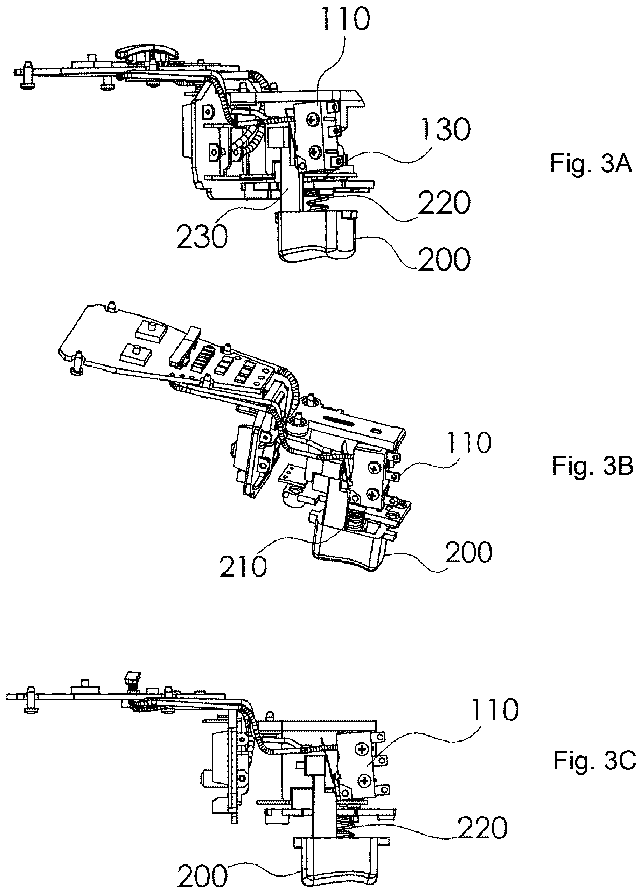

Figures 3A to 3C show a trigger apparatus 100 for a powered device and the trigger 200. Figures 3A and 3B show perspective views of the trigger apparatus 100 from different angles, and Figure 3C shows a side view of the trigger apparatus 100.

Figure 3A shows the push button 200 as the trigger being biased in the first position P1 by the helical spring 220. As the push button 220 is moved by the user, the helical spring 220 is compressed and an arm 230 of the push button 220 actuates the microswitch 110, which generates an activation signal S.

The magnet 210 is placed in the region which the linear Hall effect sensor 130 measures the magnetic field with the highest sensitivity, and the magnet 210 is moved along an axis intersecting the sensing surface of the linear Hall effect sensor 130. This allows the trigger apparatus 100 to accurately detect changes in the magnetic field generated by the magnet 210.

As shown on Figures 3B and 3C, the magnet 210 is placed within the helical spring 220, and thus does not require additional space on the trigger 200, thereby reducing the space requirements of the trigger 200.

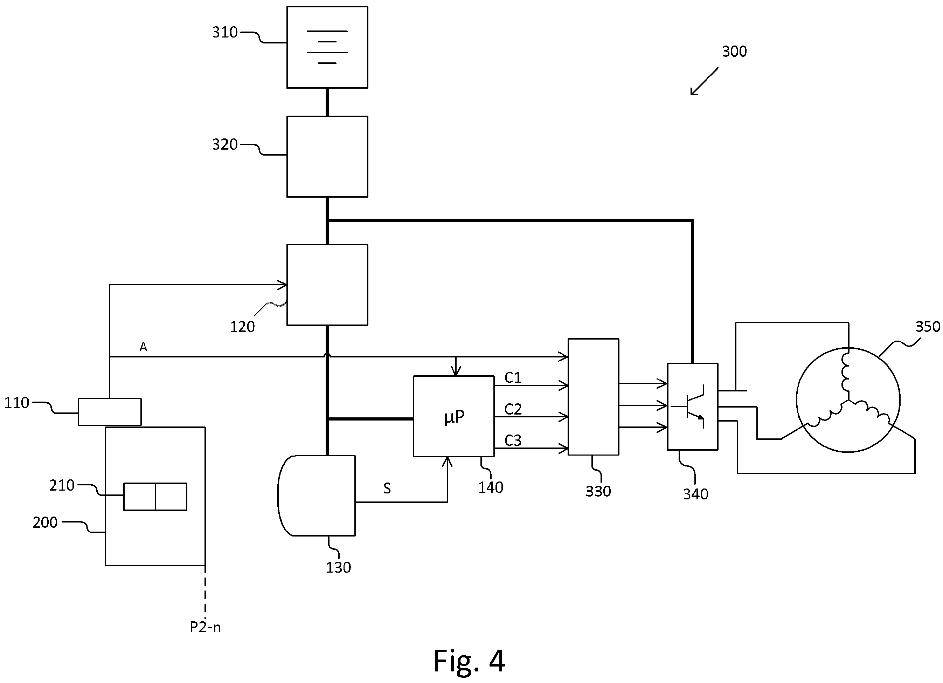

Figure 4 shows a schematic view of the trigger apparatus 100 in an electric sander 300 as a powered device.

The electric sander 300 comprises the battery 310, a power supply module 320, a logic circuit 330, a motor drive 340, and an electric motor 350.

The battery 310 supplies power to the power supply module 320, which in turns supplies power to the power module 120 and the motor drive 340.

The logic circuit 330 receives the activation signal A, which indicates the state of the microswitch 110, and the three control signals C1 ~ C3 from the microcontroller 140, and outputs signals to control the motor drive 340.

The logic circuit 330 performs a logical AND operation on the activation signal A and each of the control signals C1 ~ C3. That is, if the output of the microswitch 110 is a logical high, indicating that the trigger 200 is moved from the first position P1, the logic circuit 330 allows the control signals C1 ~ C3 to be transmitted to the motor drive 340.

Otherwise, the logic circuit 330 outputs logical low signals thereby interrupting the supply of power to the electric motor 350 and thus interrupting the motor operation.

The motor drive 340 receives the signals output by the logical circuit 340 and drives the electric motor 350 accordingly.

In the present embodiment, the motor drive 340 has a three-phased DC to AC converter in a half-bridge configuration to drive each of the phase windings of the electric motor 350 using the power supplied by the power supply module 320.

The electric motor 350 is a three-phased brushless DC (BLDC) motor having a rotor including permanent magnets and electrically commutated stator windings. The user can variably control the rotation speed of the BLDC motor 350 by controlling the movement of the trigger 200 from the first position P1 to one of the second positions P2-1 ~ P2-n.

The control signals C1 ~ C3 are generated using a pulse-width modulation to operate the BLDC motor at the speed determined by the user, using a pulse-width modulation and an indication of the current speed of the motor.

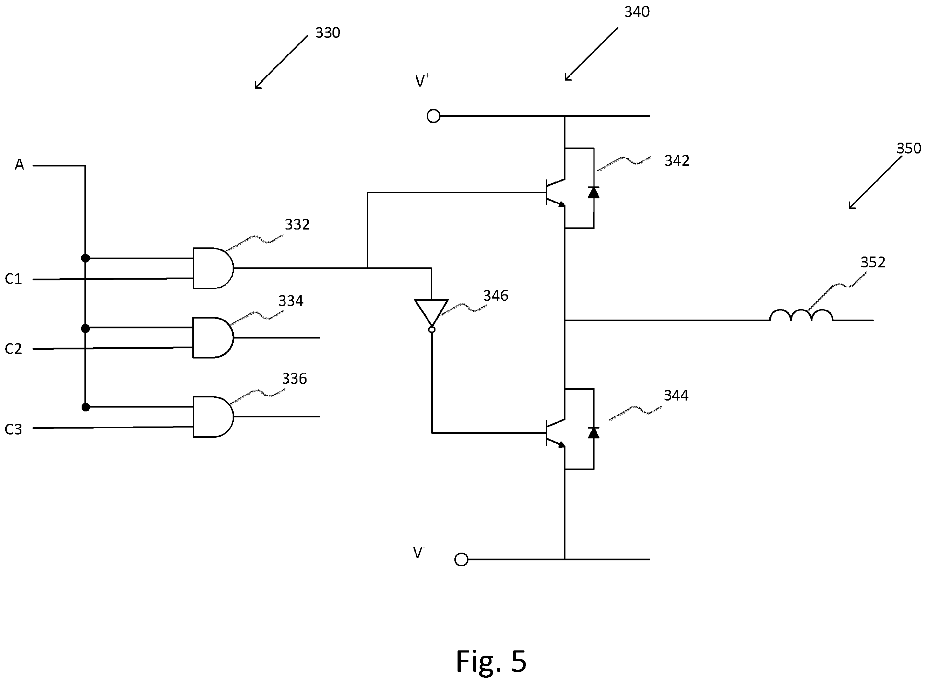

Figure 5 shows a schematic view of the logic gate 330, and parts of the motor drive 340 and the BLDC motor 350.

The logic gate 330 comprises three logical AND gates 332, 334 and 336. The AND gates each receives the activation signal A from the microswitch 110 as one of the input, and a respective one of the control signals C1 ~ C3 from the controller 140 as the other input. Therefore, the output of AND gate 332 can only be a logical high if the activation signal is a logical high. Accordingly, the activation and deactivation signals from the microswitch can disable an input of the motor drive 340.

Figure 5 also shows the part of the motor drive 340 used to control one phase of the BLDC motor 350. The motor drive 340 comprises a pair of IGBTs 342 and 344 which are connected in series to the DC voltage provided by the power supply module 320, indicated with the V+ and V- on Figure 5. The output of the AND gate 332 is connected to the gate terminal of IGBT 342 and to an inverter 346. The output of the inverter 346 is connected to the gate terminal of IGBT 344, such that the IGBTs 342 and 344 are not simultaneously on.

The common node of IGBTs 342 and 344 is connected to the phase winding 352 of the BLDC motor 350. The control signal C1 is used to determine if an electric path is formed from terminal V+ to the phase winding 352 via IGBT 342 or an electric path is formed from terminal V- to the phase winding 352 via IGBT 344, and consequently to determine the magnetic field generated by the current in the phase winding 352.

Although Figure 5 shows only one pair of IGBTs and one phase winding, it would be apparent to a person skilled in the art that the number of IGBT pairs in the motor drive 340 corresponds to the number of phase windings in the electric motor 350.

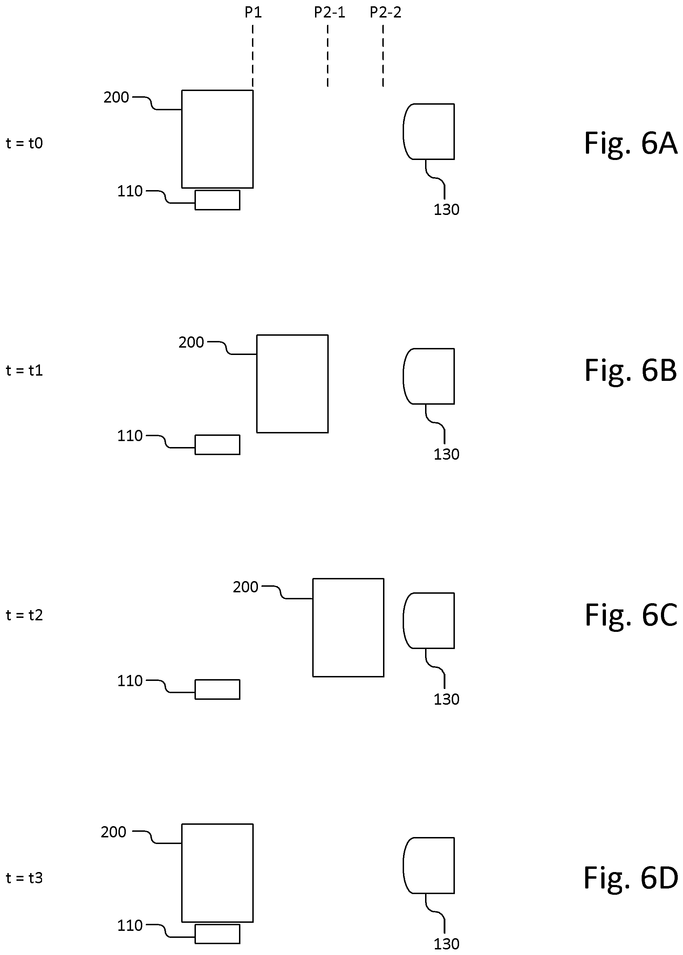

Figures 6A to 6D show a schematic view of the push button 200, the microswitch 110 and the linear Hall effect sensor 130 at different time instants t0, t1, t2 and t3 during an operation of the push button 200 by the user.

At time instant t=t0, shown on Figure 6A, the push button 200 is moved from the first position P1.

At time instant t=t1, shown on Figure 6B, the push button 200 is moved to the second position P2-1.

At time instant t=t2, shown on Figure 6C, the push button 200 is moved to another second position P2-2.

At time instant t=t3, shown on Figure 6D, the push button 200 is released by the user and moved back to the first position P1 by the coil spring 220 acting on the push button 200.

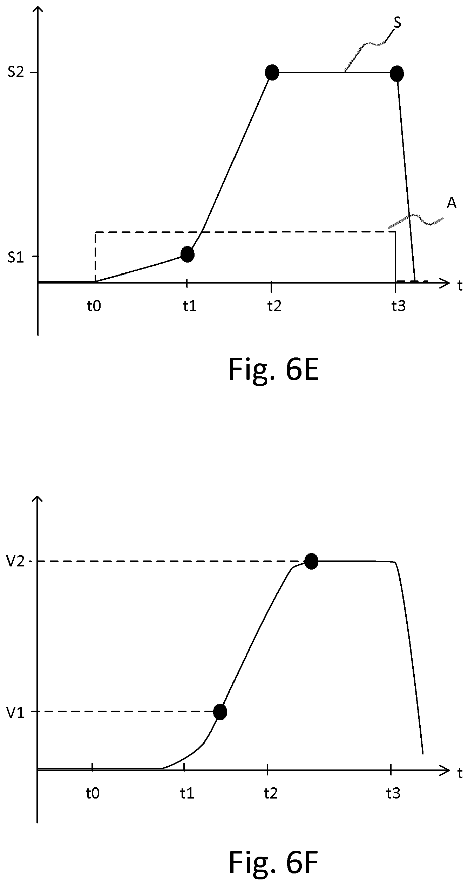

Figures 6E show the output of the microswitch 110 (that is, the activation signal and the deactivation signal), and the sensor signal S at the time instants t0 to t3.

Figure 6F show the speed of the BLDC motor 350 at the time instants t0 to t3.

At time instant t=t0, the microswitch 110 is actuated, and its output switches to a logical high, thereby generating the activation signal. At that time instant, the sensor signal S is at a negligibly low value, and the BLDC motor 350 is still.

At time instant t=t1, the sensor signal S increases to a value S1. As a result the microcontroller 140 controls the BLDC motor 350 to rotate at speed V1, which is achieved shortly after t1.

Between time instants t1 and t2, the push button 200 is moved from position P2-1 to P2-2. As a result, the amplitude of the sensor signal S increases continuously, to reach a second value S2, higher than S1. The microcontroller 140 receiving the sensor signal S increase the rotation speed of the BLDC motor 350 to a second speed V2 higher than speed V1.

At time instant t=t3, the output A of the microswitch switches to a logical low, thereby generating the deactivation signal.

The power module 120 receiving the deactivation signal interrupts the power being provided to the linear Hall effect sensor 130, which results in the amplitude of sensor signal S to drop rapidly to zero.

Upon receiving the deactivation signal, the microcontroller 140 generates a second activation signal to the power module 120 so that the microcontroller 140 is continued to be powered for a predetermined period of time after the push button 200 is moved back to the first position P1. During that period of time, the microcontroller 140 reduces the rotation speed of the BLDC motor 350 until complete stop whilst avoiding an unsafe sudden stop of the motor.

Then, the microcontroller 140 generates a second deactivation signal to the power module 120. The power module 120 receiving the second deactivation signal interrupts the power being provided to the microcontroller 140.

### [Second Embodiment]

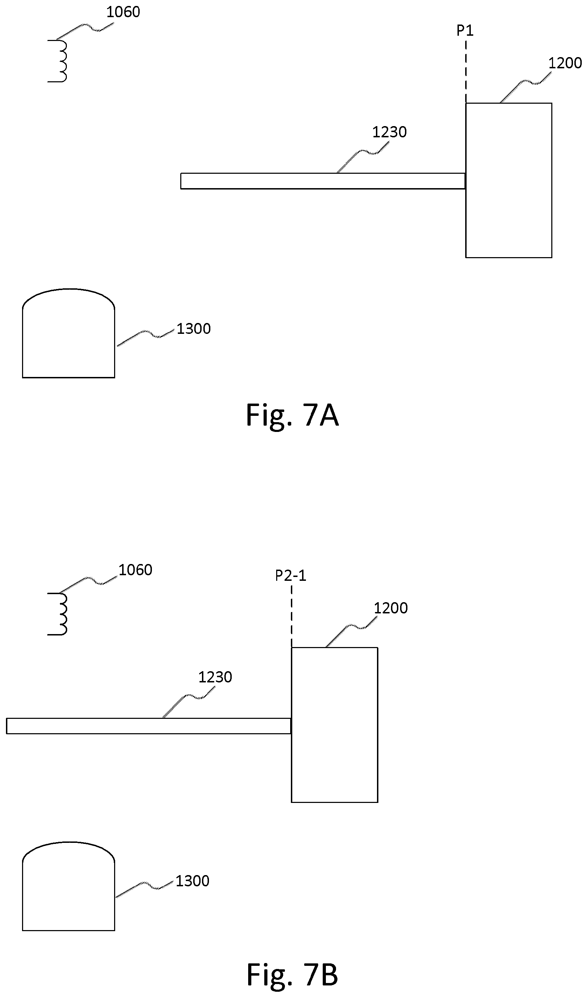

Figures 7A and 7B show a schematic view of a trigger 1200, a linear Hall effect sensor 1300 and a coil 1060 as a magnetic element, according to a second embodiment.

The coil 1060 is used to generate the magnetic field, instead of the permanent magnet 230. Additionally, the coil 1060 has a fixed positional relationship with the linear Hall effect sensor 1300, and is located near the linear Hall effect sensor 1300.

The coil 1060 is electrically coupled to an AC power source (not shown) selectively providing a constant amplitude AC current to the coil 1060 when the trigger 1200 is away from the first position P1.

The coil 1060 generates a periodic magnetic field, which can be measured by the linear Hall effect sensor 1300, to generate a sensor signal S having the same periodicity as the periodic magnetic field and an amplitude proportional to the density of the periodic magnetic field.

The trigger 1200 comprises a magnetic shielding element 1230 configured to move between the coil 1060 and the linear Hall effect sensor 1300 as the trigger 1200 is moved from the first position P1 (shown on Figure 7A) to the second position(s) P2-1 ~ P2-n (shown on Figure 7B).

The magnetic shielding element 1230, made for example of a mu-metal, is configured to increasingly attenuate the magnetic field density in the vicinity of the linear Hall effect sensor 1300 as the trigger is moved further away from the first position P1. Accordingly, the density of the periodic magnetic field generated by the coil in the vicinity of the linear Hall effect sensor 1300 is reduced as the trigger 1200 is moved further from the first position P1.

By comparing successive maximum in the periodic sensor signal, the microcontroller 140 can detect a change in the magnetic field, and determine a movement of the trigger associated with the change in the magnetic field.

### [Modifications and variations]

The permanent magnet 210 of the first embodiment may be replaced by the coil 1060 of the second embodiment or any other magnetic element. Similarly, the coil 1060 of the second embodiment may be replaced by a permanent magnet or any other magnetic element.

In the first embodiment, the permanent magnet 210 is in the trigger 200 and moves, relative to the linear Hall effect sensor 130, by movement of the trigger 200. Instead, the linear Hall effect sensor 130 may be in the trigger 200 such that it is moved, relative to the permanent magnet 210, by movement of the trigger 200.

In the second embodiment, the trigger 1200 comprises the magnetic shielding element 1230. Instead, the magnetic shielding element 1230 may be positioned between the coil 1060 and the linear Hall effect sensor 1300, and the trigger 1200 may be configured such that a movement of the trigger 1200 causes the magnetic shield to be moved away from the coil 1060 and the linear Hall effect sensor 1300, such that the maximum density of the magnetic field measured by the linear Hall effect sensor 1300 increases as the trigger 1200 is moved from the first position.

In the first embodiment, the output of the microswitch is described as being continuously at a logical high until the push button 200 is moved back to the first position. Instead, the actuation of the microswitch when the push button is moved past position P1' may cause a short impulse generated by an impulse generator connected to the terminal of the microswitch 110, which is received by the power module 120, the microcontroller 140 and the logic gate 330. Similarly, moving the push button 200 back to the first position P1 may generate another short impulse which is received by the microcontroller 140, which would correspond to a predetermined event.

The power module 120 comprises a timer which is initiated by the reception of the activation signal A, and the power module 120 provides power to the linear Hall effect sensor and the microcontroller 140 until expiration of the timer. The microcontroller 140 periodically generates the second activation signal to reset the timer in the power module 120, such that the linear Hall effect sensor 130 and the microcontroller 140 are continuously powered. When the microcontroller 140 receives the short impulse corresponding to a deactivation signal, the microcontroller may stop generating the second activation signal so that the power module 120 interrupts the power being provided to the linear Hall effect sensor 130 and the microcontroller upon expiry of the timer. Alternatively, the power module 120 may receive the deactivation signal (an example of a predetermined event) directly and interrupt the power being provided to the microcontroller 140 and the linear Hall effect sensor 130.

The logic gate 330 comprise a logical buffer circuit, such as a J-K flip-flop, configured to change its output depending on the state of the inputs, and to use the activation signal and the deactivation signal as inputs to the buffer circuit.

Accordingly, even if the activation signal is a short impulse, the logic gate 330 may continue to allow the control signals to be provided to the motor drive 340 until the logic gate 330 receives a deactivation impulse signal, which resets the output of the buffer circuit.

In the First embodiment, the power source is described as a 10.8V battery providing DC power. However, the power source may also be an external AC power source, in which case the power supply module 320 comprises an AC to DC converter to provide DC power to the power module 120. The value of the voltage described to be provided by the battery in the embodiment (10.8 V) is merely illustrative and the battery may provide any other voltage. Similarly, the battery in the present disclosure is not limited to Li-ion batteries but may be of any other known type of batteries such as lead acid batteries, nickel metal hybrid or Zinc based batteries.

In the First embodiment, the magnet 210 is kept in the region in which the linear Hall effect sensor 130 measures the magnetic field with the highest sensitivity, and is moved along an axis towards or away from the linear Hall effect sensor 130. However, the push button 200 may alternatively be configured to move the magnet 210 from a position which is not in the region in which the linear Hall effect sensor 130 measures the magnetic field with the highest sensitivity, towards that region, thereby increasing the density of the magnetic field measured by the linear Hall effect sensor.

Alternatively, the push button 200 may be configured to change the orientation of the poles of the magnet 210 relative to the linear Hall effect sensor 130, for example by rotating the magnet 210 about itself, without changing the distance or the position of the magnet 210 relative to the linear Hall effect sensor 130.

In embodiments described above, the powered device is an electric sander comprising a BLDC motor 350. However, the electric sander may alternatively comprise another type of motor having a variably controllable speed, or the powered device may be another power tool having for example an actuator which controls an amount of output flow. In case the trigger apparatus 100 is used to control an actuator, the microcontroller 140 may generate a single control signal C1 for controlling the position of the actuator.

In embodiments described above, the movement of the trigger causes a corresponding movement of the magnetic element towards the linear Hall effect sensor 130. However, it would be apparent that the movement of the trigger may cause the magnetic element away from the linear Hall effect sensor 130.

In the present disclosure, the terms logical high and logical low are used to describe two distinct states of a binary signal. Conventionally, the logical high represents the state when an electrical conductor carrying the signal is at a relatively higher voltage than the logical low. However, the use of logical high and logical low in the present disclosure can be inverted.

In embodiments described above, the trigger is a push button 200 biased by a helicoid spring 220. However, the trigger may equally be a slider configured to move along a body of the powered device, or a rotatable knob. Similarly, the trigger may be biased into the first position by any other resilient means than a helicoid spring, such as a torsion spring, a resilient rubber, etc.

In the first embodiment described above, the magnet is affixed to the push button 200, such that a movement of the push button causes the same movement of the magnet. However, the push button 200 may alternatively be configured to indirectly cause a movement of a magnet located away from the push button. For example, the push button 200 may cause a translational movement of a rod or another element which is in contact with the magnet such that a movement of the rod causes a movement of the magnet. The trigger apparatus may be configured such that a small movement of the push button causes a larger movement of the magnet, thereby allowing the trigger apparatus to determine even small movements of the trigger by the user.

In embodiments described above, the predetermined event may correspond to the reception of the deactivation signal by the power module, the reception of the second deactivation signal by the power module, or the expiry of a timer after last reception of a second activation signal by the power module. Alternatively or additionally, the powered device may have an error detection functionality configured to interrupt power in case an error or fault occurs in the device, and the predetermined event may correspond to the reception, by the power module, of an error signal indicating that the device should be powered down.

In embodiments described above, the microcontroller 140 is configured to output one control signal (C1, C2, C3) for each phase of the motor which is received by the logic circuit 330, and the logic circuit drives both switching elements of a pair based on the same signal and the inverter 346.

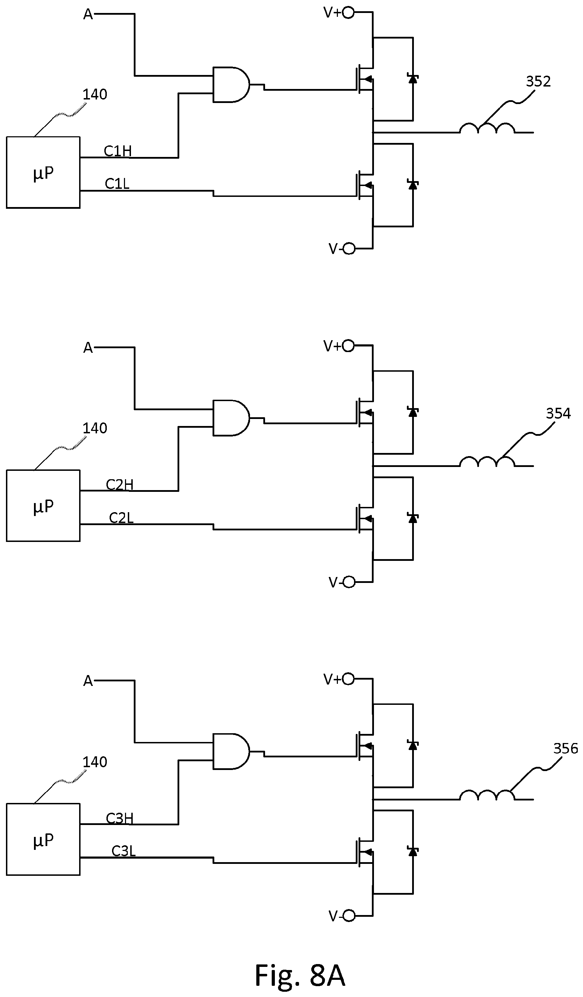

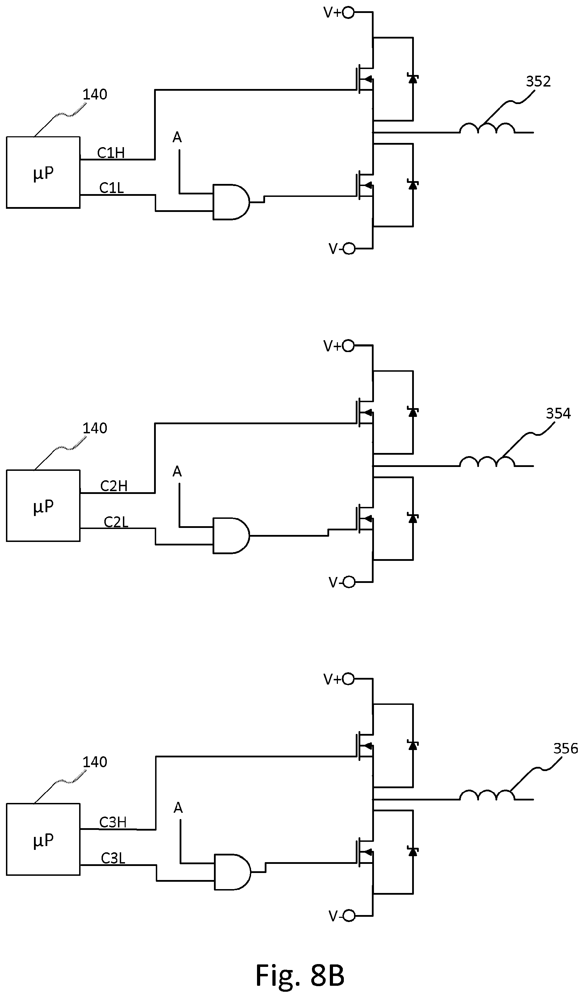

Alternatively, as shown on Figures 8A and 8B, the microcontroller 140 may output a pair of control signals for each phase windings 352, 354, 356 of the motor, namely a first pair of control signals C1H and C1L, a second pair C2H and C2L, and a third pair C3H and C3L.

In each pair of control signals, only one of the control signals is output to the logic circuit 330, and the other control signal is used to control one of the switching elements in each pair of the motor drive 340 directly.

The logic circuit 330 performs separate logical AND operations on the activation signal A and each one of the control signals it receives, and the output of each AND operation is used to control the other one of the switching elements in each pair.

With this configuration, it is possible to cause the motor to brake without an interaction from the microswitch.

Figure 8A shows the situation where the switching elements connected to the higher voltage terminal V+ are driven by the output of the logic circuit 330, while the switching elements connected to the lower voltage terminal V- are driven by the control signals output by the microcontroller 140 directly. However, as shown on Figure 8B, the opposite situation may be used where the switching elements connected to the lower voltage terminal V- are controlled by the signals output by the logic circuit 330 while the switching elements connected to the higher voltage terminal V+ are controlled by the signals output by the microcontroller 140.

In embodiments described above, the switching elements are described as IGBTs 342, 344. However, as shown on Figures 8A and 8B, MOSFETS may be used as the switching elements, each MOSFET being connected in parallel with a diode (e.g. a regular diode or a Schottky diode).

In embodiments described above, the trigger apparatus is used in a power tool having an electric motor or an actuator. However, the trigger apparatus may be used in any other powered device, such as a remote controller for a remote controlled vehicle. In that case, the one or more control signals generated by the controller may be used to generate one or more radio signals to control the remote controlled vehicle.

In embodiments described above, the activation switch is a microswitch. However, it may alternatively be a reed switch or a binary Hall effect sensor.

In embodiments described above, the motor is described as comprising three phase windings. However, it would be understood by the person skilled in the art that embodiments described in the present disclosure may equally be used with motors having other configurations, for example motors having a different number of phase windings and/or a different number of rotor poles. Similarly, the WYE representation of the phase windings is illustrative, and the phase windings may also be described with a delta configuration instead.

All of the above is fully in the scope of the disclosure, and are considered to form the basis for alternative embodiments in which one or more combinations of the above-described features are applied, without limitation to the specific combinations disclosed above.

In light of this, there will be many alternatives which implement the teaching of the present disclosure. It is expected that one skilled in the art will be able to modify and adapt the above disclosure to suit their own circumstances and requirements within the scope of the present disclosure, while retaining some or all technical effects of the same, either disclosed or derivable from the above, in light of his common general knowledge in this art. The present invention is defined by the appended claims.

### [Reference numerals]

- 100:: Trigger apparatus
- 110:: microswitch
- 120:: power module
- 130:: linear Hall effect sensor
- 140:: microcontroller
- 150:: low-voltage power bus
- 1060:: coil
- A:: activation signal
- S:: sensor signal
- C1~C3, C1H~C3H, C1L~C3L:: control signals

- 200, 1200:: trigger
- 210:: permanent magnet
- 220:: helical spring
- 1230:: magnetic shielding element
- P1:: first position
- P2-1 ~ P2-n:: second position(s)

- 300:: electric sander
- 310:: battery
- 320:: power supply module
- 330:: logic circuit
- 340:: motor drive
- 350:: electric motor
- 352-356:: phase windings

## Claims

1. A trigger apparatus (100) for a powered device (300), such as a power tool, the powered device comprising a trigger operable (200; 1200) by a user to move from a first position (P1) to at least one second position (P2-1 ... P2-N) so as to control an operation of the powered device, the trigger apparatus comprising:
a linear Hall effect sensor (130) for measuring a change in a magnetic field associated with the trigger being moved from the first position to the at least one second position, and configured to generate a sensor signal (S) for controlling the operation of the powered device based on the change in the magnetic field;
a power module (120) configured to power, the linear Hall effect sensor, upon reception of an activation signal (A) for indicating that the trigger apparatus is to be activated;
an activation switch (110) configured to generate the activation signal, when the trigger is moved from the first position, wherein the activation switch is a microswitch; and
a controller (140) configured to receive the sensor signal and for generating one or more control signals (C1; C2; C3) to control the operation of the powered device,
wherein the power module is configured to power the controller upon reception of the activation signal, and
wherein the controller is configured to generate a second activation signal for causing the power module to continue to power the controller for a specific duration.

2. The trigger apparatus (100) according to claim 1 comprising the trigger (200; 1200), and wherein the trigger apparatus is configured such that a movement of the trigger from the first position (P1) to the at least one second position (P2-1 ... P2-N) causes a change in the magnetic field measured by the linear Hall effect sensor (130).

3. The trigger apparatus (100) according to claim 1 or claim 2, comprising a magnetic element (210; 220) for generating a magnetic field.

4. The trigger apparatus (100) according to claim 3, wherein the trigger apparatus is configured such that the trigger (200; 1200) being moved from the first position (P1) to the at least one second position (P2-1 ... P2-N) causes a corresponding change to a positional relationship between the magnetic element (210; 220) and the linear Hall effect sensor (130) by way of movement of the trigger.

5. The trigger apparatus (100) according to any one of claim 1 to 4, wherein the trigger (200; 1200) is operable by the user to reversibly move between the first position (P1) and the at least one second position (P2-1 ... P2-N), and wherein:
the power module (120) is configured to stop powering the linear Hall effect sensor (130) upon reception of a deactivation signal for indicating that the trigger apparatus is to be deactivated; and
the activation switch (110) is configured to generate the deactivation signal when the trigger is moved to the first position.

6. The trigger apparatus (100) according to claim 5, wherein
the controller (140) is configured to receive the deactivation signal from the activation switch (110) and transmit a second deactivation signal to the power module (120); and
the power module is configured to stop powering the controller upon reception of the second deactivation signal.

7. A powered device (300) comprising the trigger apparatus (100) of any one of claims 1 to 6, the powered device comprising:
the trigger (200; 1200);
an electric motor (350); and
a power supply module (320) for receiving power from a power source (310) and configured to provide power to at least one of the power module of the trigger apparatus and the electric motor,
wherein the powered device is configured to operate the electric motor based on the sensor signal (S).

8. The powered device (300) according to claim 7, further comprising a drive circuit (340) for driving the electric motor (350);
wherein the controller (140) is configured to generate the one or more control signals (C1; C2; C3) to control the drive circuit, based on the sensor signal (S); and
the activation switch (110) is configured to disable at least one input of the drive circuit when the trigger is at the first position (P1) so as to interrupt an operation of the electric motor.

9. A method of controlling an operation of a powered device (300), preferably according to any of the preceding claims 7 and 8, the device comprising a trigger (200; 1200) operable by a user to move from a first position (P1) to at least one second position (P2-1 ... P2-N) so as to control the operation of the device, the method comprising:
generating, using an activation switch (100), an activation signal (A) when the trigger is moved from the first position, wherein the activation switch is a microswitch;
powering a linear Hall effect sensor (130) and a controller (140) upon generation of the activation signal;
measuring, using the linear Hall effect sensor, a change in a magnetic field associated with the trigger being moved from the first position to the at least one second position;
generating, a sensor signal (S) for controlling the operation of the powered device based on the change in the magnetic field;
receiving, by the controller, the sensor signal; and
generating, by the controller, one or more control signals (C1; C2; C3) to control the operation of the device based on the sensor signal,
wherein the controller is configured to generate a second activation signal for causing the power module to continue to power the controller for a specific duration.

## Patentansprüche

1. Auslöseeinrichtung (100) für eine angetriebene Vorrichtung (300), wie z.B. ein Elektrowerkzeug, wobei die angetriebene Vorrichtung einen Auslöser (200; 1200) umfasst, der von einem Benutzer betätigt werden kann, um sich von einer ersten Position (P1) in mindestens eine zweite Position (P2-1... P2-N) zu bewegen, um den Betrieb der angetriebenen Vorrichtung zu steuern, wobei die Auslösevorrichtung umfasst:
einen linearen Hall-Effekt-Sensor (130) zum Messen einer Änderung in einem Magnetfeld, die damit verbunden ist, dass der Auslöser von der ersten Position in die mindestens eine zweite Position bewegt wird, und der konfiguriert ist, um ein Sensorsignal (S) zum Steuern des Betriebs der angetriebenen Vorrichtung auf der Grundlage der Änderung in dem Magnetfeld zu erzeugen;
ein Leistungsmodul (120), das konfiguriert ist, um den linearen Hall-Effekt-Sensor mit Strom zu versorgen, wenn es ein Aktivierungssignal (A) empfängt, das anzeigt, dass die Auslösevorrichtung aktiviert werden soll;
einen Aktivierungsschalter (110), der konfiguriert ist, um das Aktivierungssignal zu erzeugen, wenn der Auslöser aus der ersten Position bewegt wird, wobei der Aktivierungsschalter ein Mikroschalter ist; und
eine Steuereinrichtung (140), die konfiguriert ist, um das Sensorsignal zu empfangen und ein oder mehrere Steuersignale (C1; C2; C3) zu erzeugen, um den Betrieb der angetriebenen Vorrichtung zu steuern,
wobei das Leistungsmodul konfiguriert ist, um die Steuereinrichtung bei Empfang des Aktivierungssignals mit Strom zu versorgen, und
wobei die Steuereinrichtung konfiguriert ist, um ein zweites Aktivierungssignal zu erzeugen, um zu bewirken, dass das Leistungsmodul die Steuereinrichtung für eine bestimmte Dauer weiter mit Strom versorgt.

2. Auslöseeinrichtung (100) nach Anspruch 1, umfassend den Auslöser (200; 1200) und wobei die Auslöseeinrichtung konfiguriert ist, so dass eine Bewegung des Auslösers von der ersten Position (P1) in die mindestens eine zweite Position (P2- 1... P2-N) eine Änderung des vom linearen Hall-Effekt-Sensor (130) gemessenen Magnetfelds bewirkt.

3. Auslöseeinrichtung (100) nach Anspruch 1 oder Anspruch 2, umfassend ein magnetisches Element (210; 220) zum Erzeugen eines Magnetfeldes.

4. Auslöseeinrichtung (100) nach Anspruch 3, wobei die Auslöseeinrichtung konfiguriert ist, so dass der Auslöser (200; 1200) von der ersten Position (P1) in die mindestens eine zweite Position (P2-1... P2-N) bewegt wird, bewirkt durch die Bewegung des Auslösers eine entsprechende Änderung der Lagebeziehung zwischen dem magnetischen Element (210; 220) und dem linearen Halleffektsensor (130).

5. Auslöseeinrichtung (100) nach einem der Ansprüche 1 bis 4, wobei der Auslöser (200; 1200) durch den Benutzer betätigbar ist, um sich reversibel zwischen der ersten Position (P1) und der mindestens einen zweiten Position (P2-1... P2-N) zu bewegen, und wobei:
das Leistungsmodul (120) konfiguriert ist, um die Stromversorgung des linearen Hall-Effekt-Sensors (130) bei Empfang eines Deaktivierungssignals zu beenden, das anzeigt, dass die Auslösevorrichtung deaktiviert werden soll; und
der Aktivierungsschalter (110) konfiguriert ist, um das Deaktivierungssignal zu erzeugen, wenn der Auslöser in die erste Position bewegt wird.

6. Auslöseeinrichtung (100) nach Anspruch 5, wobei
die Steuereinrichtung (140) konfiguriert ist, um das Deaktivierungssignal vom Aktivierungsschalter (110) zu empfangen und ein zweites Deaktivierungssignal an das Leistungsmodul (120) zu senden; und
das Leistungsmodul konfiguriert ist, um die Stromversorgung der Steuereinrichtung bei Empfang des zweiten Deaktivierungssignals zu unterbrechen.

7. Angetriebene Vorrichtung (300) umfassend die Auslöseeinrichtung (100) nach einem der Ansprüche 1 bis 6, die angetriebene Vorrichtung umfassend:
den Auslöser (200; 1200);
einen elektrischen Motor (350); und
ein Leistungsversorgungsmodul (320) zum Empfangen von Strom von einer Stromquelle (310), das konfiguriert ist, um Strom an das Leistungsmodul der Auslösevorrichtung und/oder den Elektromotor zu liefern,
wobei die angetriebene Vorrichtung konfiguriert ist, um den Elektromotor auf der Grundlage des Sensorsignals (S) zu betreiben.

8. Angetriebene Vorrichtung (300) nach Anspruch 7, weiter umfassend eine Ansteuerschaltung (340) zum Ansteuern des Elektromotors (350);
wobei die Steuereinrichtung (140) konfiguriert ist, dass sie das eine oder die mehreren Steuersignale (C1; C2; C3) erzeugt, um die Antriebsschaltung auf der Grundlage des Sensorsignals (S) zu steuern; und
der Aktivierungsschalter (110) konfiguriert ist, um mindestens einen Eingang der Treiberschaltung zu deaktivieren, wenn sich der Auslöser in der ersten Position (P1) befindet, so dass ein Betrieb des Elektromotors unterbrochen wird.

9. Verfahren zum Steuern eines Betriebs der angetriebenen Vorrichtung (300), vorzugsweise nach einem der vorstehenden Ansprüche 7 und 8, die Vorrichtung umfassend einen Auslöser (200; 1200), der von einem Benutzer betätigt werden kann, um sich von einer ersten Position (P1) in mindestens eine zweite Position (P2-1... P2-N) zu bewegen, um so den Betrieb der Vorrichtung zu steuern, das Verfahren umfassend:
Erzeugen eines Aktivierungssignals (A) mittels eines Aktivierungsschalters (100), wenn der Auslöser aus der ersten Position bewegt wird, wobei der Aktivierungsschalter ein Mikroschalter ist;
Versorgen eines linearen Hall-Effekt-Sensors (130) und einer Steuereinrichtung (140) bei Erzeugung des Aktivierungssignals;
Messen einer Änderung des Magnetfeldes, die mit der Bewegung des Auslösers von der ersten Position in die mindestens eine zweite Position verbunden ist, mit Hilfe des linearen Hall-Effekt-Sensors;
Erzeugen eines Sensorsignals (S) zum Steuern des Betriebs der angetriebenen Vorrichtung auf der Grundlage der Änderung des Magnetfelds;
Empfangen des Sensorsignals durch die Steuereinrichtung; und
Erzeugen eines oder mehrerer Steuersignale (C1; C2; C3) durch die Steuereinrichtung, um den Betrieb der Vorrichtung auf der Grundlage des Sensorsignals zu steuern,
wobei die Steuereinrichtung konfiguriert ist, um ein zweites Aktivierungssignal zu erzeugen, um zu bewirken, dass das Leistungsmodul die Steuereinrichtung für eine bestimmte Dauer weiter mit Strom versorgt.

## Revendications

1. Appareil de déclenchement (100) pour un dispositif alimenté (300), tel qu'un outil électrique, le dispositif alimenté comprenant un déclencheur actionnable (200 ; 1200) par un utilisateur pour passer d'une première position (P1) à au moins une seconde position (P2-1... P2-N) de manière à commander une opération du dispositif alimenté, l'appareil de déclenchement comprenant :
un capteur linéaire à effet Hall (130) permettant de mesurer une variation dans un champ magnétique associée au déplacement du déclencheur de la première position à la au moins une seconde position, et configuré pour générer un signal de capteur (S) permettant de commander l'opération du dispositif alimenté sur la base de la variation dans le champ magnétique ;
un module d'alimentation (120) configuré pour alimenter le capteur linéaire à effet Hall lors de la réception d'un signal d'activation (A) permettant d'indiquer que l'appareil de déclenchement doit être activé ;
un commutateur d'activation (110) configuré pour générer le signal d'activation, lorsque le déclencheur est déplacé de la première position, dans lequel le commutateur d'activation est un microcommutateur ; et
un dispositif de commande (140) configuré pour recevoir le signal de capteur et permettant de générer un ou plusieurs signaux de commande (C1 ; C2 ; C3) de manière à commander l'opération du dispositif alimenté,
dans lequel le module d'alimentation est configuré pour alimenter le dispositif de commande lors de la réception du signal d'activation, et
dans lequel le dispositif de commande est configuré pour générer un second signal d'activation permettant d'amener le module d'alimentation à continuer à alimenter le dispositif de commande pendant une durée spécifique.

2. Appareil de déclenchement (100) selon la revendication 1 comprenant le déclencheur (200 ; 1200), et dans lequel l'appareil de déclenchement est configuré de telle sorte qu'un déplacement du déclencheur de la première position (P1) à la au moins une seconde position (P2-1... P2-N) entraîne une variation dans le champ magnétique mesuré par le capteur linéaire à effet Hall (130).

3. Appareil de déclenchement (100) selon la revendication 1 ou la revendication 2, comprenant un élément magnétique (210 ; 220) permettant de générer un champ magnétique.

4. Appareil de déclenchement (100) selon la revendication 3, dans lequel l'appareil de déclenchement est configuré de telle sorte que le déplacement du déclencheur (200 ; 1200) de la première position (P1) à la au moins une seconde position (P2-1... P2-N) entraîne une variation correspondante d'une relation positionnelle entre l'élément magnétique (210 ; 220) et le capteur linéaire à effet Hall (130) au moyen d'un déplacement du déclencheur.

5. Appareil de déclenchement (100) selon l'une quelconque des revendications 1 à 4, dans lequel le déclencheur (200 ; 1200) est actionnable par l'utilisateur pour passer de manière réversible entre la première position (P1) et la au moins une seconde position (P2-1... P2-N), et dans lequel :
le module d'alimentation (120) est configuré pour arrêter d'alimenter le capteur linéaire à effet Hall (130) lors de la réception d'un signal de désactivation permettant d'indiquer que l'appareil de déclenchement doit être désactivé ; et
le commutateur d'activation (110) configuré pour générer le signal de désactivation lorsque le déclencheur est déplacé dans la première position.

6. Appareil de déclenchement (100) selon la revendication 5, dans lequel
le dispositif de commande (140) est configuré pour recevoir le signal de désactivation en provenance du commutateur d'activation (110) et transmettre un second signal de désactivation au module d'alimentation (120) ; et
le module d'alimentation est configuré pour arrêter d'alimenter le dispositif de commande lors de la réception du second signal de désactivation.

7. Dispositif alimenté (300) comprenant l'appareil de déclenchement (100) selon l'une quelconque des revendications 1 à 6, le dispositif alimenté comprenant :
le déclencheur (200 ; 1200) ;
un moteur électrique (350) ; et
un module d'alimentation électrique (320) permettant de recevoir une alimentation provenant d'une source d'alimentation (310) et configuré pour fournir une alimentation à au moins l'un du module d'alimentation de l'appareil de déclenchement et du moteur électrique,
dans lequel le dispositif alimenté est configuré pour actionner le moteur électrique sur la base du signal de capteur (S).

8. Dispositif alimenté (300) selon la revendication 7, comprenant en outre un circuit d'entraînement (340) permettant d'entraîner le moteur électrique (350) ;
dans lequel le dispositif de commande (140) est configuré pour générer les un ou plusieurs signaux de commande (C1 ; C2 ; C3) de manière à commander le circuit d'entraînement, sur la base du signal de capteur (S) ; et
le commutateur d'activation (110) est configuré pour désactiver au moins une entrée du circuit d'entraînement lorsque le déclencheur est à la première position (P1) de manière à interrompre une opération du moteur électrique.

9. Procédé de commande d'une opération d'un dispositif alimenté (300), de préférence selon l'une quelconque des revendications précédentes 7 et 8, le dispositif comprenant un déclencheur (200 ; 1200) actionnable par un utilisateur pour passer d'une première position (P1) à au moins une seconde position (P2-1... P2-N) de manière à commander l'opération du dispositif, le procédé comprenant :
la génération, en utilisant un commutateur d'activation (100), d'un signal d'activation (A) lorsque le déclencheur est déplacé de la première position, dans lequel le commutateur d'activation est un microcommutateur ;
l'alimentation d'un capteur linéaire à effet Hall (130) et d'un dispositif de commande (140) lors de la génération du signal d'activation ;
le mesurage, en utilisant le capteur linéaire à effet Hall, d'une variation dans un champ magnétique associée au déplacement du déclencheur de la première position à la au moins une seconde position ;
la génération d'un signal de capteur (S) permettant de commander l'opération du dispositif alimenté sur la base de la variation dans le champ magnétique ;
la réception, par le dispositif de commande, du signal de commande ; et
la génération, par le dispositif de commande, d'un ou plusieurs signaux de commande (C1 ; C2 ; C3) pour commander l'opération du dispositif sur la base du signal de capteur,
dans lequel le dispositif de commande est configuré pour générer un second signal d'activation permettant d'amener le module d'alimentation à continuer à alimenter le dispositif de commande pendant une durée spécifique.
